Europäisches Patentamt

European Patent Office

Office européen des brevets

(11) Publication number: **0 257 912**
**A2**

# (12) EUROPEAN PATENT APPLICATION

(21) Application number: **87307107.0**

(22) Date of filing: **11.08.87**

(51) Int. Cl.4: **G11C 11/40** , G11C 7/00

(30) Priority: **29.08.86 JP 203337/86**
**29.08.86 JP 203366/86**

(43) Date of publication of application:
**02.03.88 Bulletin 88/09**

(84) Designated Contracting States:
**DE FR GB**

(71) Applicant: **Kabushiki Kaisha Toshiba**
**72, Horikawa-cho Saiwai-ku**
**Kawasaki-shi Kanagawa-ken 210(JP)**

Applicant: **Toshiba Micro-Computer**
**Engineering Corporation**
**2-11, Higashida-cho Kawasaki-ku**
**Kawasaki-shi Kanagawa-ken(JP)**

(72) Inventor: **Isobe, Matsuo c/o Patent Division**
**Toshiba Corporation §1-1 Shibaura 1-chome**
**Minato-ku§Tokyo(JP)**
Inventor: **Iizuka, Tetsuya c/o Patent Division**
**Toshiba Corporation §1-1 Shibaura 1-chome**
**Minato-ku§Tokyo(JP)**
Inventor: **Aono, Akira c/o Patent Division**
**Toshiba Corporation §1-1 Shibaura 1-chome**
**Minato-ku§Tokyo(JP)**

(74) Representative: **Sturt, Clifford Mark et al**
**MARKS & CLERK 57-60 Lincoln's Inn Fields**
**London WC2A 3LS(GB)**

(54) Static semiconductor memory device.

(57) This invention provides a static semiconductor memory device comprising, a plurality of static memory cells (10) for data storage, bit lines (11A, 11B) connected to the memory cells (10) for transferring data to and from the memory cells (10), a sense amplifier (17) having an input terminal, for amplfying the potential of the bit lines (11A, 11B) when data is transferred from the memory cells (10), and potential lowering device (30A, 30B) connected to the input terminal for lowering the potential of the input terminal of the sense amplifier (17) to a potential corresponding to substantially the optimum sensitivity of the sense amplifier (17) for increasing the speed of data transfer in the memory device.

Fig. 5

# Static semiconductor memory device

This invention relates to semiconductor memory devices. In particular, it relates to an improved static random access memory wherein data can be read at high speed from memory cells.

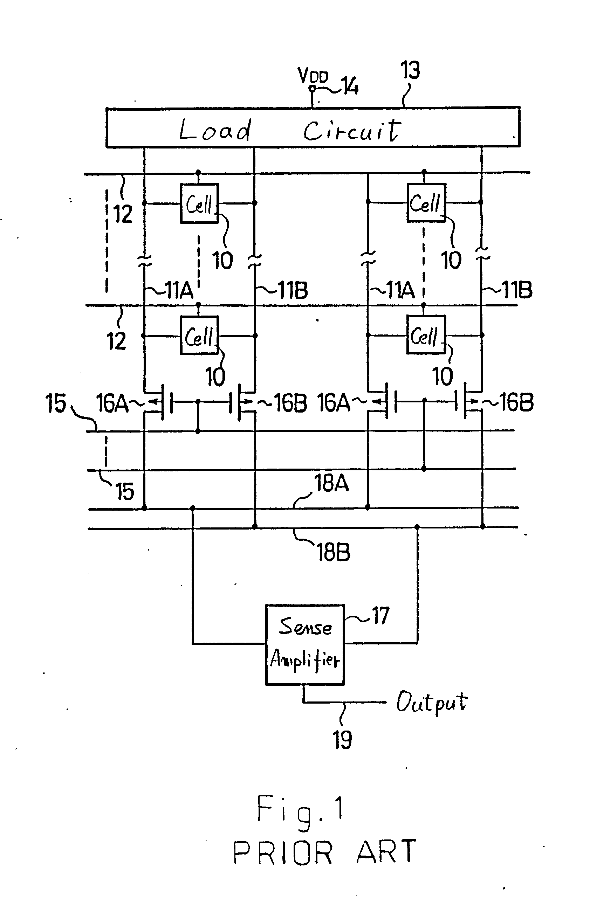

Fig. 1 is a block diagram showing the construction of a conventional static random access memory (hereinafter abbreviated as S-RAM). In this Figure, reference numeral 10 designates static memory cells, 11A and 11B are bit lines that receive and transmit data between these memory cells 10, while 12 designates word lines for simultaneously selecting cells from the aforementioned plurality of memory cells 10 in the column direction. Numeral 13 represents a load circuit that charges bit lines 11A and 11B at the power source potential $V_{DD}$ applied to power source terminal 14, 15 refers to column decoding lines that select cells from the plurality of memory cells 10 in the row direction, 16A and 16B are MOS transistors for bit line selection that transfer the data of bit lines 11A, 11B to a sense amplifier 17, 18A and 18B are input lines connected to a pair of input terminals of sense amplifier 17, and 19 is an output line of sense amplifier 17.

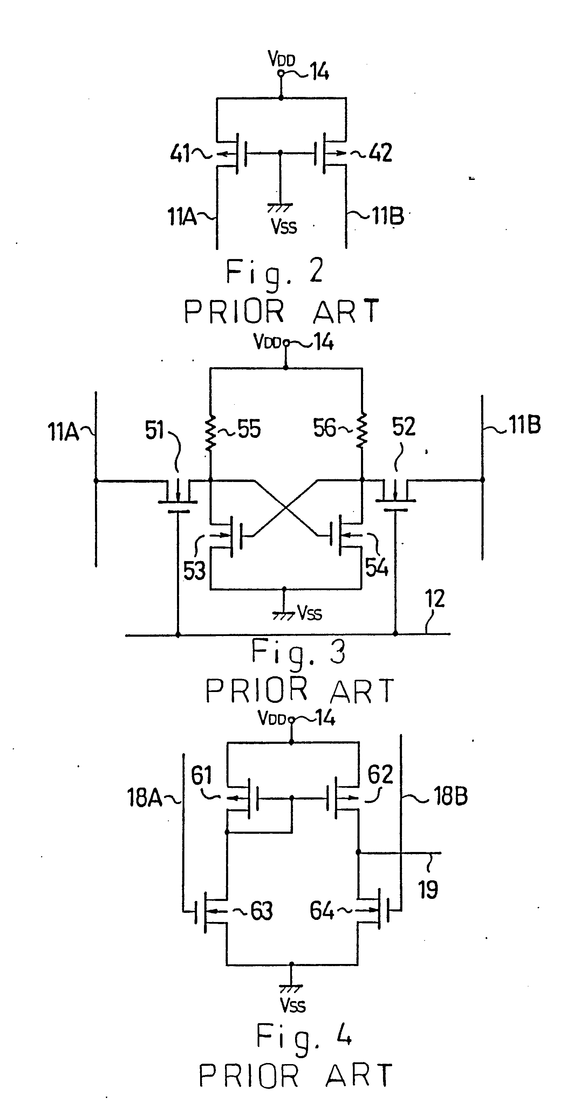

Fig. 2 is a circuit diagram showing the specific construction of load circuit 13 in this conventional S-RAM. The source-drain paths of p-channel MOS transistors 41 and 42 are respectively inserted between each of pair of bit lines 11A and 11B and power source terminal 14 to which power source voltage $V_{DD}$ is applied. The gates of transistors 41 and 42 are connected to standard potential ($V_{SS}$, or ground potential), and the two transistors 41 and 42 are thus normally conducting.

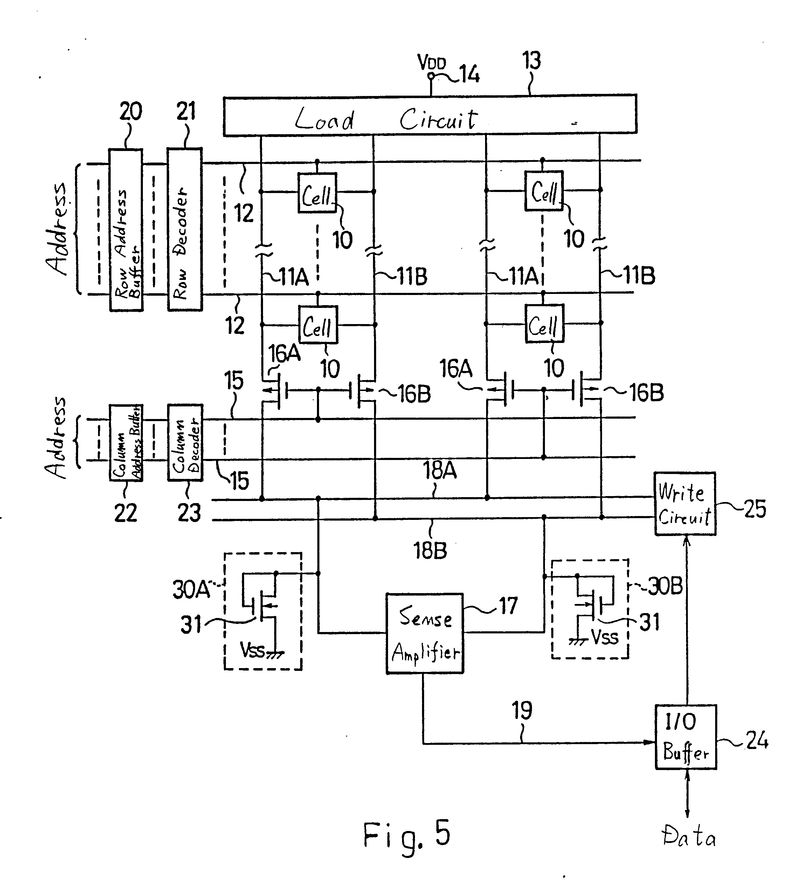

Fig. 3 is a circuit diagram showing the specific construction of memory cells 10 in this conventional S-RAM. Specifically, reference numerals 51 and 52 are n-channel MOS transistors serving as transfer gates, 53 and 54 are n-channel MOS drive transistors, and 55 and 56 are high resistances serving as loads. One terminal of each transfer gate MOS transistor 51 and 52 is connected to one of pair of bit lines 11A and 11B, respectively, and their gates are connected in common to word line 12. The respective sources of drive MOS transistors 53 and 54 are connected in common to standard potential $V_{SS}$. Their gates and drains are cross-connected, and the drains are connected to the other terminal of each MOS transistor 51 and 52 serving as transfer gates. One terminal of each high resistance 55 and 56 is connected to the drain of one of the MOS transistors 53 and 54, respectively, while the other terminal of each resistance is connected to power source terminal 14. Thus transistor 53 and high resistance 55, and transistor 54 and high resistance 56 constitute respective inverters. By connecting the inputs and outputs of these two inverters, a flip-flop circuit is formed that stores statically 1-bit data.

Fig. 4 is a circuit diagram that shows a specific construction of sense amplifier 17 in the conventional S-RAM. In general, this sense amplifier amplifies at high speed small potential differences generated on a pair of bit lines, and is constructed as shown. The respective sources of p-channel MOS transistors 61 and 62 are connected in common to power source terminal 14, and the gates of two transistors 61 and 62 are connected in common, the point of common connection of these gates being in turn connected to the drain of transistor 61. The drain of n-channel MOS transistor 63 is connected to the drain of transistor 61, and the source of this transistor 63 is connected to standard potential $V_{SS}$. Likewise the drain of n-channel MOS transistor 64 is connected to the drain of transistor 62, and the source of this transistor 64 is connected to standard potential $V_{SS}$. The gates of two transistors 63 and 64 are connected to input lines 18A and 18B, respectively. Thus amplified data is output from the common drain of transistors 62 and 64. This type of sense amplifier is generally called a current mirror load type sense amplifier. Its output drive capability is high, so it is widely used.

In an S-RAM of such a construction, when data is written to memory cell 10, a specific single memory cell 10 is selected by using an address input, row decoder and column decoder, not shown, to select a specific word line 12 and column decoding line 15. Write data from a write circuit, not shown, is then fed to input lines 18A and 18B. In this process, this write data is supplied to bit lines 11A and 11B through the pair of MOS transistors 16A and 16B. The transistors 16A and 16B are selected by column decoding line 15. This sets one of the bit lines 11A and 11B to "H" level, while the other is set to "L" level. After this, data writing to pre-selected memory cell 10 is performed in accordance with the potential of bit lines 11A and 11B.

In the read operation, a memory cell 10 is selected as in the write operation, and the potential of bit lines 11A and 11B changes in accordance with the data that is read from this selected memory cell 10. These potential changes are transmitted to input lines 18A and 18B of sense amplifier 17. Sense amplifier 17 then amplifies this potential difference and outputs data corresponding to the read data of memory cell 10 from its output terminal 19. This data is output to the outside through a data output circuit, not shown.

The power source voltage $V_{DD}$ usually used in an S-RAM is +5V. However, recently the systems in which S-RAM's are used are being made smaller, and operation by means of a battery is now often required. To guarantee operation using for example a 3V battery, p-channel MOS transistors must be used for MOS transistors 41 and 42 employed in load circuit 13, shown in Fig. 2. The reason for this is that if n-channel MOS transistors are used instead of p-channel MOS transistors, the potential of the bit lines 11A and 11B is lowered from the power source voltage +3V by the amount of the threshold voltage of the n-channel MOS transistor, to which the "back-gate effect" is added. Specifically, the potential of the bit lines 11A, 11B cannot be made more than about +1.5V. Data cannot be correctly read and written at such a potential.

If however p-channel MOS transistors are used for MOS transistors 41 and 42, no voltage drop occurs in load circuit 13, since the threshold voltage of p-channel MOS transistors is of a negative polarity. The potential of one or the other of bit lines 11A and 11B therefore rises to the power source voltage +3V, and correct reading and writing of data can be performed.

However, since conventionally a p-channel MOS transistor is used as the load of bit lines 11A and 11B, when data read from memory cell 10 is output to bit lines 11A and 11B, their potential only falls slightly from power source voltage. The reason is that there is a limit to the size of drive MOS transistors 53 and 54 that constitute memory cell 10. They cannot be made unduly large or too much space would be required. The potential of the bit line that drops to level "L", therefore, falls only slightly from the power source voltage. For example, if the power source voltage is +5V, the potential of one of the bit lines is +5V, while that of the other bit line will be about +4.5V. Sense amplifier 17 has to amplify this slight potential difference at high speed. However, a sense amplifier constructed as in Fig. 4 is designed to have its highest sensitivity at an input potential about midway between power source voltage $V_{DD}$ and standard potential $V_{SS}$. There is therefore the drawback in a conventional S-RAM that since the bit line potential varies in the vicinity of the power source voltage, it is difficult to amplify the bit line potential difference at high speed, so data cannot be read at such high speeds.

Thus in the conventional device there is a problem in that data reading cannot be carried out at high speed, since the input potential of the sense amplifier cannot be lowered.

An object of this invention is to provide a static semiconductor memory device that can be operated in a stable manner even at a power source voltage lower than the normal voltage, and which can operate at high speed even with normal power source voltage.

This invention provides a static semiconductor memory device comprising, a plurality of static memory cells for data storage, bit lines connected to the memory cells for transferring data to and from the memory cells, a sense amplifier having an input terminal, for amplifying the potential of the bit lines when data is transferred from the memory cells, and potential lowering device connected to the input terminal for lowering the potential of the input terminal of the sense amplifier to a potential corresponding to substantially the optimum sensitivity of the sense amplifier for increasing the speed of data transfer in the memory device.

With the static semiconductor memory device of this invention, because of the use of a potential lowering means which lowers the potential generated at the input terminals of the sense amplifier, the sense amplifier can be operated at substantially its point of optimum sensitivity.

Embodiments of the invention will now be described by way of example only and with reference to the accompanying drawings, in which :-

Fig. 1 is a block diagram showing the construction of a conventional device.

Fig. 2 to Fig. 4 are circuit diagrams respectively showing specific parts of the conventional device and the invention.

Fig. 5 is a block diagram showing the construction of an embodiment of this invention.

Fig. 6 to Fig. 8 are circuit diagrams showing the construction of main parts of further embodiments of this invention.

Fig. 9 is a block diagram showing the construction of yet a further embodiment of this invention.

Fig. 10 is a block diagram showing the construction of a further embodiment of this invention.

Fig. 11 is a block diagram showing the construction of a further embodiment of this invention.

Fig. 12 is a block diagram showing the construction of yet a further embodiment of this invention.

Fig. 5 is a block diagram showing the construction of a static semiconductor memory device according to this invention. In this Figure, reference numeral 10 represents static memory cells, 11A and 11B are bit lines that receive and transmit data between these memory cells 10, 12 designates word lines for simultaneous selection of a plurality of these memory cells 10 in the column direction, 13 is a load circuit that charges bit lines 11A and 11B with the power source voltage $V_{DD}$ applied to power source terminal 14, 15 is a column decoding line that selects a plurality of memory cells 10 in the row direction, 16A and 16B are MOS transistors for selecting the bit line of bit lines 11A and 11B on which the data is to be transmitted to sense amplifier 17, 18A and 18B are input lines connected to a pair of input terminals of this sense amplifier 17, 19 is the output line of sense amplifier 17, 20 is a row address buffer, 21 is a row decoder that selects and drives a word line 12 in accordance with the output of this row address buffer 20, 22 is a column address buffer, 23 is a column decoder that selects and drives column decoding line 15 in accordance with the output of this column address buffer 22, 24 is an I/O buffer that temporarily stores the write data that are fed from outside and the read data that are output from sense amplifier 17, and 25 is a write circuit that sets the potential of input lines 18A and 18B of sense amplifier 17 in accordance with this write data when write data that was stored in this I/O buffer 24 is supplied and data writing is performed.

In this embodiment, potential lowering circuits 30A and 30B are respectively inserted between each of the pair of input lines 18A and 18B of sense amplifier 17 and the standard potential $V_{SS}$. N-channel MOS transistors 31 are provided in these two potential lowering circuits 30A and 30B. The sources of these transistors 31 are connected to standard potential $V_{ss}$ and their drains and gates are connected in common to the input lines 18A and 18B.

Specific circuit configurations of load circuit 13, memory cell 10, and sense amplifier 17 in this embodiment may be the same as in Fig. 2, Fig. 3 and Fig. 4 described above.

In the construction described above, when data is to be read from a memory cell 10, a specific word line 12 is selected by the output of row decoder 21, and a specific single memory cell 10 is selected by selecting a column decoder line 15 by the output of column decoder 23. At this point all the bit lines 11A and 11B are charged up to power source potential $V_{DD}$ by p-channel MOS transistors 41 and 42 in load circuit 13, of which a specific configuration is shown in Fig. 2. When in this condition a single memory cell 10 is selected, the potential of bit lines 11A and 11B that are connected to this cell varies in accordance with the data that is read out from the selected memory cell. More specifically, the potential of one or the other of bit lines 11A, 11B stays at power source potential $V_{DD}$, but the potential of the other bit line drops slightly from power source potential $V_{DD}$ in accordance with the read data. Potential lowering circuits 30A and 30B are connected between respective input lines 18A and 18B of sense amplifier 17 and standard potential $V_{SS}$. When, in these potential lowering circuits 30A and 30B, the drain and gate potentials of n-channel MOS transistors 31 exceed the sum of the threshold voltage of these transistors 31 and standard potential $V_{SS}$, a current flow path is formed between respective input lines 18A and 18B and standard potential $V_{SS}$. As a result, when data reading is performed, and a specific column decoding line 15 is selected in accordance with the output of column decoder 23, transistors 16A and 16B conduct, causing bit lines 11A and 11B and input lines 18A and 18B to become connected through transistors 16A and 16B. Then the respective potentials of bit lines 11A and 11B fall from their initial potential when data reading is performed. That is, both the "1" potential level and "0" potential level on input line 18A and 18B falls lower than the potential on bit line 11A and 11B. This potential drop depends on the dimensional ratio of transistors 41 and 42 within load circuit 13 and transistor 31 within potential lowering circuit 30A and 30B, i.e., on the ratio channel length and channel width, etc. Thus by suitably setting this ratio, it is possible to arrange that the input potential after the potential drop is in the vicinity of the potential at which the sensitivity of sense amplifier 17 is at its highest.

For example, with no potential lowering circuits 30A and 30B, assume the "1" potential level of bit lines 11A and 11B is +5V after data reading, and their "0" potential level is +4.5V. Addition of potential lowering circuits 30A and 30B enables these potentials to be lowered by, for example, 2V, to +3V and +2.5V, respectively. Such input potentials practically coincide with the point of maximum sensitivity of sense amplifier 17 (in the neighbourhood of +2.5V). Since the conductivity ratio of transistors 31 and 41 is 2:3, the potential level of bit line 11A is lowered to +3V or +2.5V. The potential level of bit line 11A depends on the conductivity ratio of transistors 31 and 41. Since the conductivity ratio of transistors 31 and 42 is 2:3, the potential level of bit line 11B is lowered to +3V or +2.5V. The potential level of bit line 11B depends on the conductivity ratio of transistors 31 and 42.

Therefore sense amplifier 17 is able to amplify the mutual potential difference between input lines 18A and 18B with high sensitivity, so that the stored data of memory cell 10 can be rapidly output from output terminal 19. Thus this read data is output to the outside via I/O buffer 24.

In this way, since load circuit 13 in this embodiment is constituted by a p-channel MOS transistor, in which there is no voltage drop due to threshold voltage, the potentials of bit lines 11A and 11B can be raised to power source voltage $V_{DD}$. This means that stable operation can be achieved even with low power source voltage. Furthermore, because of the provision of potential lowering circuits 30A and 30B, the input potential can be set to a potential near the point of maximum sensitivity of sense amplifier 17, thereby making it possible to achieve high-speed data reading even when operating with the normal, high power source voltage.

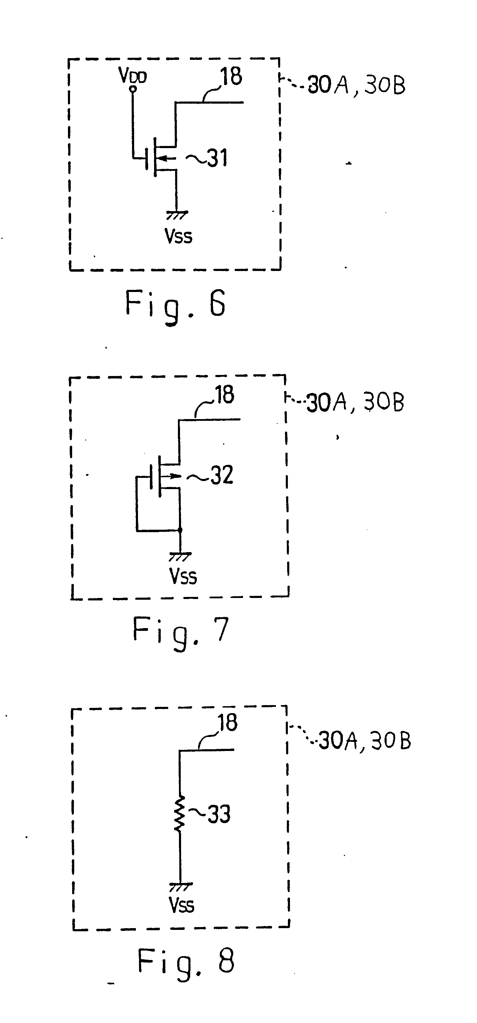

Figs. 6 to 8 are circuit diagrams showing the construction of potential lowering circuit 30A and 30B used in memory devices according to respective further embodiments of this invention.

In the case of potential lowering circuit 30A and 30B used in the embodiment of Fig. 6, instead of connecting the gate of n-channel MOS transistor 31 to input terminal 18 of sense amplifier 17, it is connected to power source terminal 14, so that it is always conducting, irrespective of the potential of input line 18.

In the case of potential lowering circuit 30A and 30B used in the embodiment of Fig. 7, a p-channel MOS transistor 32 is used instead of n-channel MOS transistor 31. In this case, the gate of this transistor 32 is connected to standard potential $V_{SS}$.

In the potential lowering circuit used in the embodiment of Fig. 8, a resistance 33 is used instead of n-channel MOS transistor 31. However, in the devices of all of the embodiments of Fig. 5 to Fig. 8, in data writing, the potential of one or the other of input lines 18A and 18B is set to "A" level by write circuit 25, and the potential of the opposite input line is set to "L" level. When this happens, because of the provision of potential lowering circuit 30A and 30B, current flows through potential lowering circuit 30A and 30B from the input line 18 that has been raised to the "H" level potential by write circuit 25. This tends to increase power consumption during data writing.

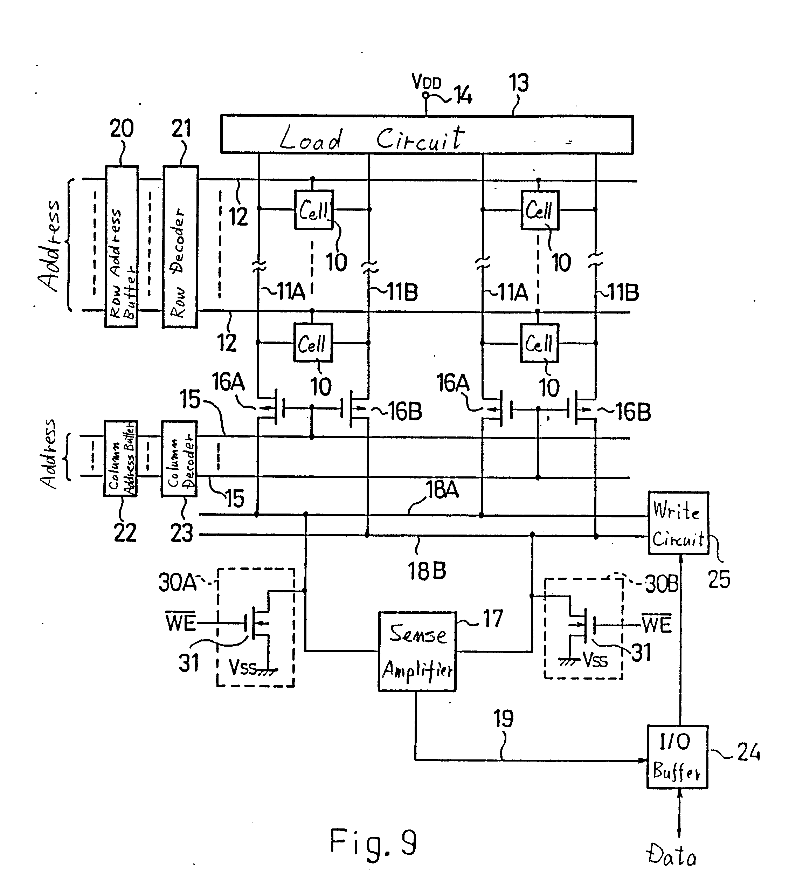

Fig. 9 is a block diagram showing the construction of a further embodiment of this invention constructed to prevent such an increase in power consumption during data writing.

In this embodiment, a write enable signal $\overline{WE}$ is supplied to the gate of n-channel MOS transistor 31 in potential lowering circuits 30A and 30B, such that conduction of transistors 31 is controlled in accordance with this signal $\overline{WE}$. This write enable signal $\overline{WE}$ is a signal that is made active ("L" level) only during data writing. The operation of write circuit 25 is controlled by means of this signal $\overline{WE}$, although not shown in the Figures.

In this embodiment, transistor 31 is made conductive only when signal $\overline{WE}$ is made non-active, i.e., during data reading. Consequently, during data writing, when signal $\overline{WE}$ is made active, no current path is formed from input lines 18A and 18B to standard potential $V_{SS}$, so unnecessary power consumption is suppressed. In this embodiment a p-channel MOS transistor can be used in place of n-channel MOS transistor 31. In this case, a signal WE would be supplied to the gate of this p-channel MOS transistor.

The above embodiments have been described for the case where the memory cells are constructed using four transistors and two resistors, with high resistance load as shown in Fig. 3. However, a six-transistor construction, wherein p-channel MOS transistors are used instead of the high resistance load, could be employed.

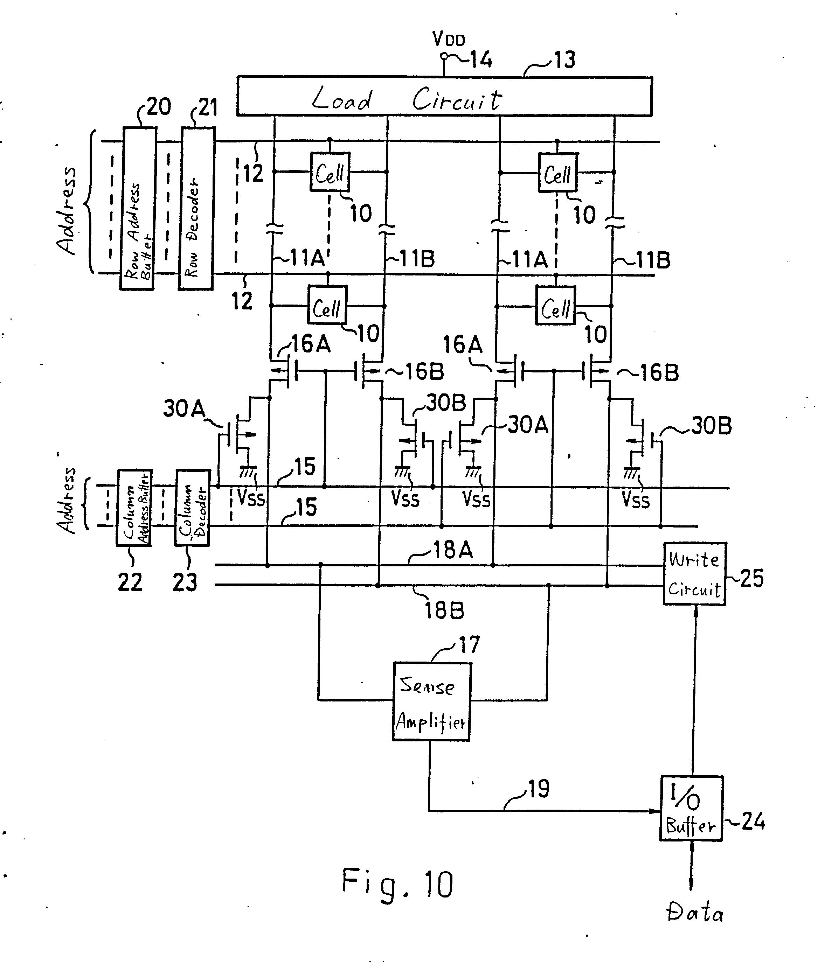

A further embodiment of this invention is described below with reference to the drawings. Fig. 10 is a block diagram showing the construction of a static semiconductor memory device according to this invention.

In this embodiment, there is also inserted, between each bit line 11A and the standard potential $V_{SS}$, the source-drain path of a p-channel MOS transistor 30A, and between each bit line 11B and the standard potential $V_{SS}$, the source-drain path of a p-channel MOS transistor 30B, respectively. The gates of each pair of transistors 30A and 30B are connected in common to corresponding column decoding line 15.

The specific circuit configurations of load circuit 13, memory cell 10, and sense amplifier 17 in this embodiment may be the same as in Fig. 2, Fig. 3 and Fig. 4, described above.

In the construction described above, when data is to be read from a memory cell 10, a specific word line 12 is selected by the output of row decoder 21, and a specific single memory cell 10 is selected by selecting a column decoder line 15 by the output of column decoder 23. At this point all the bit lines 11A and 11B are charged up to power source potential $V_{DD}$ by p-channel MOS transistors 41 and 42 in load circuit 13, of which a specific configuration is shown in Fig. 2. When a single memory cell 10 is selected, the potential of bit lines 11A and 11B that are connected to this cell varies in accordance with the data that is read out from the selected memory cell. More specifically, the potential of one or the other of bit lines 11A and 11B stays at power source potential $V_{DD}$, but the potential of the other bit line drops slightly from power source potential $V_{DD}$, in accordance with the read data. Further, when this data is read, a specific column decoder line 15 is selected in accordance with the output of column decoder 23, causing transistors 16A and 16B to conduct. When bit lines 11A and 11B and input lines 18A and 18B are now connected through transistors 16A and 16B, p-channel MOS transistors 30A and 30B that are connected to bit lines 11A and 11B become conductive. When these two transistors 30A and 30B become conductive, a current path is formed between respective bit lines 11A and 11B and standard ground potential $V_{SS}$. As a result, when data reading is performed, the respective potentials of bit lines 11A and 11B that are selected by column decoding line 15 fall from their initial potential. This potential drop depends on the dimensional ratio of transistors 30A and 30B and transistors 41 and 42 within load circuit 13, i.e., on the channel length and channel width, etc. Thus, by suitably setting this ratio, it is possible to arrange that the input potential after the potential drop is in the vicinity of the potential at which the sensitivity of sense amplifier 17 is at its highest. For example, assuming the "1" potential level of bit lines 11A and 11B is +5V, while their "0" potential level is +4.5V, addition of transistors 30A and 30B enables these potentials to be lowered by, for example, 2V, to +3V and +2.5V, respectively. Such input potentials practically coincide with the point of maximum sensitivity of sense amplifier 17 (in the neighbourhood of +2.5V). Since the conductivity ratio of transistors 30A and 41 is 2:3, the potential level of bit line 11A is lowered to +3V or +2.5V. The potential level of bit line 11A depends on the conductivity ratio of transistors 30A and 41. And, since the conductivity ratio of transistors 30B and 42 is 2:3, the potential level of bit line 11B is lowered to +3V or +2.5V. The potential level of bit line 11B depends on the conductivity ratio of transistors 30B and 42.

Therefore, sense amplifier 17 is able to amplify the mutual potential difference between input lines 18A and 18B with maximum sensitivity, so that the stored data of memory cell 10 can be rapidly output from output terminal 19. Thus, this read data is output to the outside through I/O buffer 24.

In this way, in this embodiment, since load circuit 13 is constituted by a p-channel MOS transistor, in which there is no voltage drop due to threshold voltage, the potentials of bit lines 11A and 11B can be raised to power source voltage $V_{DD}$. This means that stable operation can be achieved even with a low power source voltage. Furthermore, thanks to the provision of transistors 30A and 30B, the input potential can be set to a potential near the point of maximum sensitivity of sense amplifier 17, thereby making it possible to achieve high-speed data reading even when operating with the normal, high power source voltage.

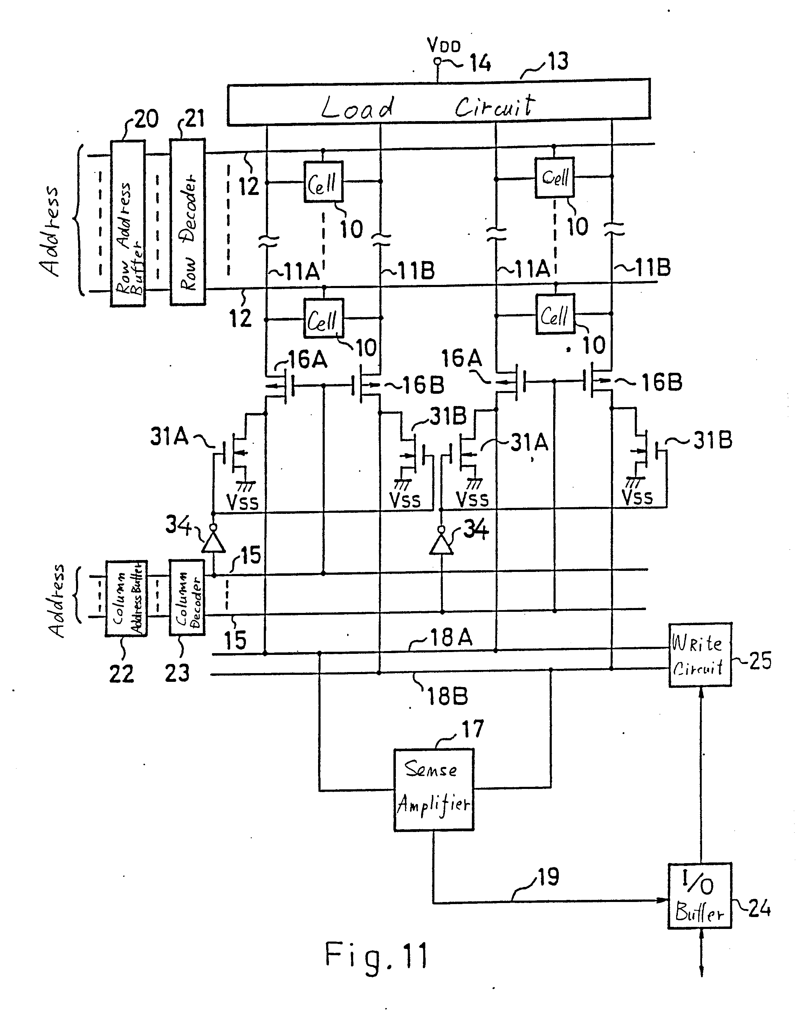

Fig. 11 is a block diagram of the configuration of a further embodiment of this invention. In this embodiment, instead of p-channel MOS transistors 30A and 30B, used in the above described embodiment of Fig. 10, n-channel MOS transistors 31A and 31B are connected between standard ground potential $V_{SS}$ and bit lines 11A and 11B. In this case the signal of column decoding line 15 is supplied to the gates of the corresponding set of transistors 31A and 31B through a respective inverter 34.

In the embodiments of Fig. 10 and Fig. 11, when data writing is performed, write circuit 25 sets one of the potentials of input lines 18A and 18B to "H" level and sets the other to "L" level. When this happens, the effect of transistors 30A and 30B or 31A and 31B is to allow current flow through transistors 30A and 30B or 31A and 31B from whichever of input lines 18A and 18B was set to "H" level potential by write circuit 25. This tends to increase the power consumption when data writing is performed.

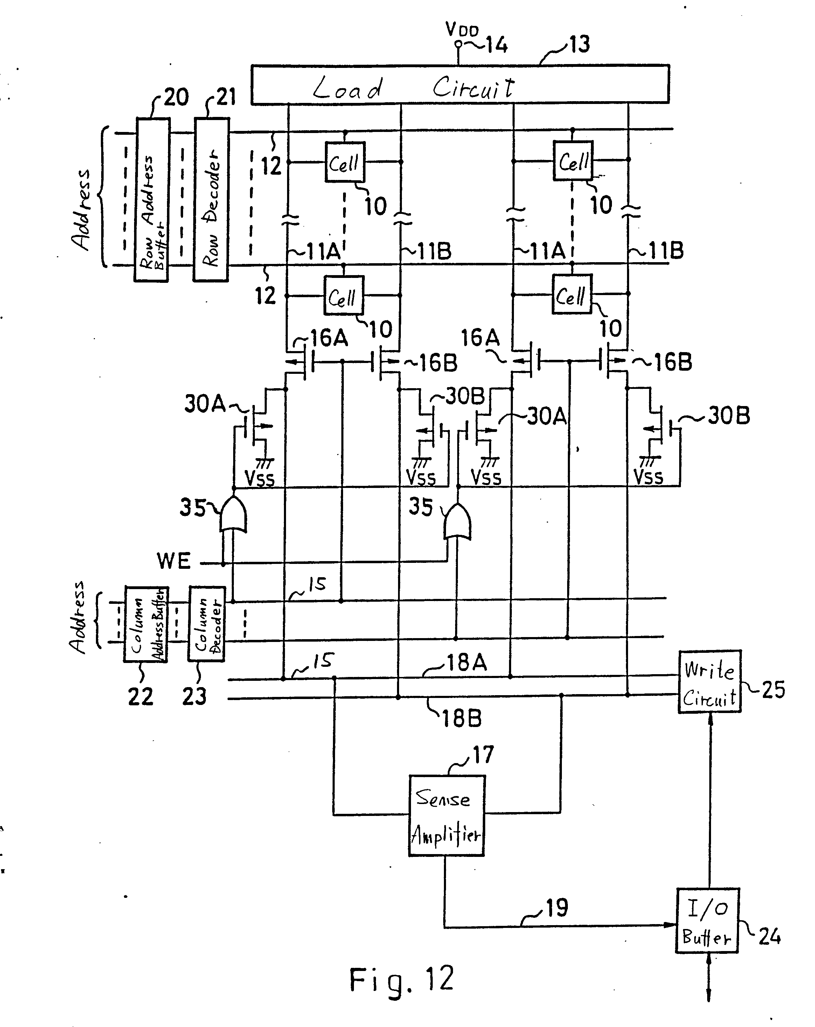

Fig. 12 shows a further embodiment of this invention in which this increase in power consumption on data writing is prevented.

In this embodiment, OR gates 35 are added to the embodiment of Fig. 10, and the signals from column decoding lines 15 and write enable signal WE are supplied to these OR gates. Conduction of corresponding transistors 30A and 30B is controlled by the outputs of these OR gates 35. This write enable signal WE is a signal that is made active ("H" level) only during data writing. Although not shown, operation of write circuit 25 is controlled by this signal WE.

In this embodiment, transistors 30A and 30B are made conductive only during data reading, i.e., when signal WE is non-active and the column decoding signal is active. As a result, in the data writing period, i.e., while signal WE is active, there is no current path to standard ground potential from input lines 18A and 18B, and unnecessary power consumption is therefore avoided.

In this embodiment n-channel MOS transistors can be used in place of p-channel MOS transistors 30A and 30B. If this is done, a NOR gate would be used instead of OR gate 35.

The above embodiments have been described for the case where the memory cells are constructed using four transistors and two resistors, with high resistance load, as shown in Fig. 3. However, a six-transistor construction, wherein p-channel MOS transistors are used instead of the high resistance load, could be employed.

As described above, the static semiconductor memory device of this invention, provides a benefit in that it can operate in a stable manner at power source voltages lower than the ordinary voltage, and also can operate at high speed at ordinary power source voltages. Furthermore, in this type of memory device, setting of the bit line potential and signal amplification has an important relationship with shortening the delay time from the memory cell to the sense amplifier output. Conventionally, setting of the bit line potential and signal amplification could only be carried out by means of the load circuit. However, with the memory device of this invention, it also can be performed using the potential lowering means. This has the benefit of increasing design freedom.

Various modifications and variations could be made to the invention without departing from the scope of the invention.

### Claims

1. A static semiconductor memory device comprising:
a plurality of static memory cells (10) for data storage;
bit lines (11A, 11B) connected to the memory cells (10) for transferring data to and from the memory cells (10); and
a sense amplifier (17) having an input terminal, for amplifying the potential of the bit lines (11A, 11B) when data is transferred from the memory cells (10); characterised by
potential lowering means (30A, 30B) connected to the input terminal for lowering the potential of the input terminal of the sense amplifier (17) to a potential corresponding to substantially the optimum sensitivity of the sense amplifier for increasing the speed of data transfer in the memory device.

2. A static semiconductor memory device as claimed in claim 1, wherein the potential lowering means includes an n-channel MOS transistor (31) connected between the input terminal of the sense amplifier (17) and a standard ground potential ($V_{SS}$), the gate and drain of the n-channel MOS transistor (31) being connected together.

3. A static semiconductor memory device as claimed in claim 2, wherein the gate of the n-channel MOS transistor (31) is connected to a prescribed drive potential (VDD).

4. A static semiconductor memory device as claimed in claim 1, wherein the potential lowering means includes a p-channel MOS transistor (32) connected between the input terminal of the sense amplifier (17) and a standard ground potential (VSS), the gate and drain of the p-channel MOS transistor (32) being connected together.

5. A static semiconductor memory device as claimed in claim 1, wherein the potential lowering means includes a resistance (33) connected between the input terminal of the sense amplifier and a standard ground potential (VSS).

6. A static semiconductor memory device as claimed in claim 1, also including column decoder means (23) for generating a bit line signal identifying the bit lines (11A, 11B) corresponding to memory cells (10) from which data is to be transferred, and wherein the potential lowering means is connected between the input terminal and a standard ground potential (VSS), and is responsive to the bit line signal.

7. A static semiconductor memory device as claimed in claim 6, wherein the potential lowering means including an n-channel MOS transistor (31A, 31B).

8. A static semiconductor memory device as claimed in claim 6, wherein the potential lowering means includes a p-channel MOS transistor (30A, 30B).

9. A static semiconductor memroy device as claimed in any preceding claim wherein the potential lowering means includes means for transmitting a current only when data is transferred from the memory cells (10).

10. A static semiconductor memory device as claimed in claim 9, wherein the transmitting means includes an n-channel MOS transistor (31A, 31B).

11. A static semiconductor memory device as claimed in claim 9, wherein the transmitting means includes a p-channel MOS transistor (30A, 30B).

12. A static semiconductor memory device as claimed in claim 10, wherein the transmitting means also includes an inverter (32).

13. A static semiconductor memory device as claimed in claim 11, wherein the transmitting means also includes an OR gate (33).

14. A static semiconductor memory device as claimed in claim 10, wherein the transmitting means also includes an NOR gate.

Fig.1
PRIOR ART

0 257 912

Fig. 2
PRIOR ART

Fig. 3
PRIOR ART

Fig. 4
PRIOR ART

Fig. 5

V_DD    18                    ----30A,30B

        ~31

Vss

Fig. 6

                18            ⌐--30A, 30B

        ~32

Vss

Fig. 7

                18            ----30A,30B

        ~33

Vss

Fig. 8

Fig. 9

Fig. 10

Fig.11

Fig. 12